# EUROPEAN PATENT APPLICATION

(11) **EP 0 673 066 A1**
(43) Date of publication of application: **20.09.1995**
(21) Application number: 95300414.0
(22) Date of filing: 24.01.1995
(51) Int. Cl.: H01L 23/467

(54) **Heat sink**

(30) Priority: 17.03.1994 JP 47163/94
(71) Applicant: FUJITSU LIMITED, Kawasaki-shi, Kanagawa 211 (JP)
(72) Inventor: Nakata, Katsuhiko, c/o Fujitsu Ltd., Kawasaki-shi, Kanagawa 211 (JP)
(74) Representative: Gibbs, Christopher Stephen

(57) **Abstract**

A heat sink 2 is disclosed which is high in cooling efficiency and superior in reliability over known heat sinks. The heat sink 2 is constituted from a base member 6, a cover member 8 and a fan assembly 10, an air sucking port 12 being provided in the cover member 8 and an air discharging port 14 in the base member 6 which are directed to the upstream side and the downstream side, respectively, of the air flow.

## Description

This invention relates to a heat sink applied to a heat generating element such as an integrated circuit package.

In recent years, as electronic apparatus for which minimization and high reliability are required, portable electronic apparatus such as, for example, lap-top personal computers have arrived widely on the market. In order to realize a high performance for the apparatus of the type mentioned, it is necessary to use one or more integrated circuit packages which generate a great amount of heat. Therefore, in order to assure high heat radiation of such heat generating element or elements, a heat sink with a fan for performing compulsory air cooling operation is used.

Meanwhile, apparatus constructed such that a cooling air flow is produced in the inside using an air exhausting fan or the like have been put into practical use, and a heat sink of a high performance which can be applied to apparatus of the type just described is demanded.

Conventionally, a heat sink is publicly known which includes a base member made of a material having a high heat conductivity and secured in a closely contacting relationship to an upper face of a heat generating element such as an integrated circuit package, and a fan for compulsorily cooling the base member by air. The fan is usually provided in an exposed condition on the upper face of the base member, and a cooling wind taken into the heat sink by the fan removes heat from the base member and is discharged in four directions sidewardly of the base member to effect heat radiation of the heat generating element.

If such a conventional heat sink as described above is applied to an apparatus which is constructed such that a cooling air flow is produced in the inside, where the heat sink is mounted, due to high density mounting, at a location at which an air flow passes a narrow flow passage or a like case, since hot winds are exhausted in four directions from discharging ports of the heat sink, the flow passages of the air flows are disordered, resulting in difficulty in efficient cooling of the apparatus. Thus, such problems as thermal destruction of a peripheral element by a hot wind are produced. Further, with the conventional heat sink, since the fan is exposed to the upper face of the heat sink, it is possible for a finger of an operator to contact the fan, for example during a mounting operation or the like, or a foreign article may enter the apparatus by way of the fan and cause it to fail.

It is therefore an object of the present invention to provide a heat sink which has a high level of efficiency and reliability.

According to the present invention, there is provided a heat sink including a housing having a base member with a lower face for contacting a heat generating element, and an air displacing means, characterised in that the housing includes an air intake port and at least one air discharge port, arranged at offset points in the housing respectively, and the air displacing means is provided in the housing for urging air between the air intake port and the or each air discharge port.

In a preferred arrangement, the heat sink is adapted to be applied to an apparatus and is constructed such that a cooling air flow is produced in the inside thereof. The base member contains a cavity and has an opening in an upper face thereof, the base member further having the air discharging port. A cover member is provided with the base member in such a manner as to cover over the opening and has the air intake port. Air displacing means is provided in the opening for urging air from the inside of the cover member into the inside of the base member, the air intake port and the air discharging port being arranged to the upstream side and the downstream side of the cooling air flow, respectively.

Advantageously a plurality of air discharge ports may be provided in an end of the base member, either all on one face, or if appropriate to the particular location, in an end face and adjacent sections of adjoining faces.

In one arrangement a plurality of doors may be provided in the or each air discharging port which can be selectively opened and closed to set the direction of discharge of air.

Since the air intake port and the air discharging port(s) are provided in the cover member and the base member, respectively, and the air intake port and the air discharging port(s) are directed to the upstream side and the downstream side, respectively, of air flow in the apparatus, the flow passage of the cooling air flow in the apparatus is less likely to be disturbed and efficient cooling of the apparatus can be achieved. Further, since the cover member is provided in such a manner as to cover over the opening of the base member in which the air blasting means is provided, the problem of possible interference with the air blasting means or fan is removed and the reliability is improved.

The above and other objects, features and advantages of the present invention and the manner of realizing them will become more apparent, and the invention itself will best be understood from a study of the following description and appended claims with reference to the attached drawings showing some preferred embodiments of the invention.
FIG. 1 is a perspective view of a heat sink to which the present invention is applied;
FIG. 2 is a sectional view of the heat sink of FIG. 1;
FIG. 3 is a perspective view of an apparatus to which the heat sink of the present invention is applied;
FIG. 4 is a sectional view of a fan assembly;
FIG. 5 is a perspective showing another example of an air discharging port;
FIG. 6A and FIG. 6B are perspective views showing other examples of a door;
FIG. 7A and FIG. 7B are perspective views showing other examples of a securing structure for a cover member.

In the following, an embodiment of the present invention will be described in detail with reference to the drawings.

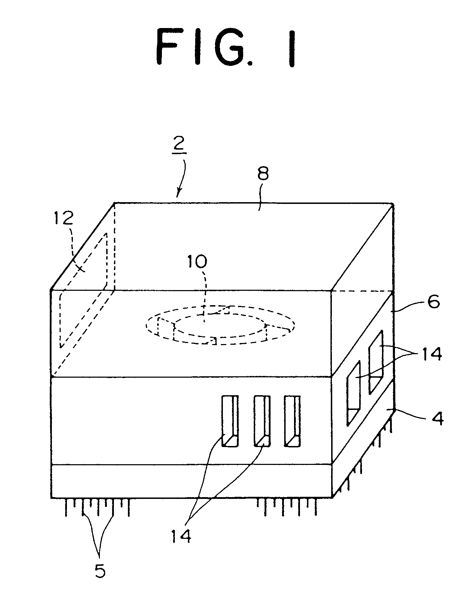

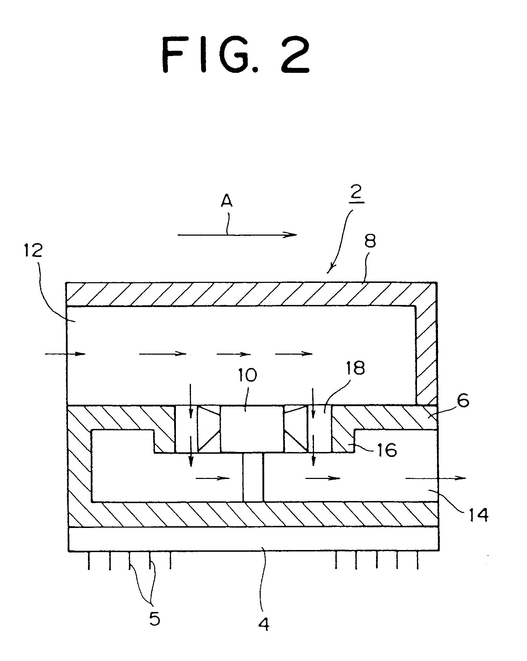

FIG. 1 is a perspective view of a heat sink to which the present invention is applied, and FIG. 2 is a sectional view of the heat sink. The heat sink 2 is carried on an integrated circuit package 4 as a heat generating element. The integrated circuit package 4 has a flat upper face, and leads 5 which are used to mount the heat sink 2 onto a printed circuit board extend from a lower face of the integrated circuit package 4.

The heat sink 2 is constituted from a base member 6 secured in a closely contacting relationship at a lower face thereof with an upper face of the integrated circuit package 4, a cover member 8 provided integrally with the base member 6, and a fan assembly 10 as air blasting means. The base member 6 and the cover member 8 are made of a metal material having a high heat conductivity such as an aluminum alloy, and the base member 6 is secured to the integrated circuit package 4 by means of adhesion, a screw or the like. A detailed example of the means for securing the cover member 8 to the base member 6 to integrate them with each other will be hereinafter described. An air sucking port 12 is formed on a side face of the cover member 8, and an air discharging port 14 is formed on a side face of the base member 6. Meanwhile, an annular projection 16 which extends into the inside of the base member is provided at an upper portion of the base member 6, and an opening 18 is formed in the upper face of the base member 6 by the annular projection 16. The fan assembly 10 is mounted at a lower portion of the base member 6 such that it is positioned within the opening 18. The fan assembly 10 is driven so that air may be fed from the inside of the cover member 8 into the inside of the base member 6.

The present invention is characterized in that the air sucking port 12 and the air discharging port 14 are directed to the upstream side and the downstream side, respectively, of a cooling air flow in an apparatus in which the heat sink 2 is mounted. In FIG. 2, the air flow is indicated by an arrow mark A. Air sucked into the cover member 8 through the air sucking port 12 is fed into the base member 6 by way of the opening 18 by the fan assembly 10 and discharged in a predetermined direction by way of the air discharging port 14. It is to be noted that, in the present embodiment, the heat sink 2 has a substantially parallelepiped-shaped configuration, and the air discharging port 14 is provided by two in a side face of the base member 6 at an end portion on the downstream side of the arrow mark A and by three in each of the two side faces parallel to the arrow mark A adjacent the downstream end portion side.

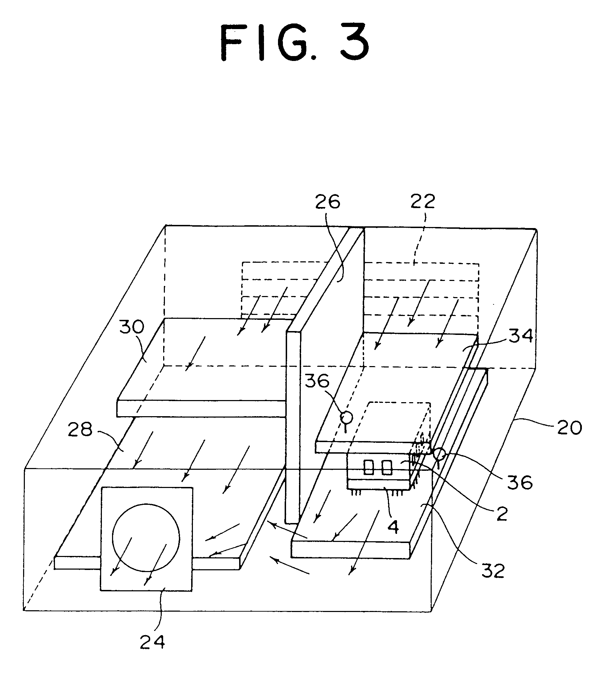

FIG. 3 is a perspective view of the apparatus to which the heat sink of the present embodiment is applied and which is constructed such that a cooling air flow is formed in the inside. An air admission opening 22 is formed in a rear face side of the apparatus 20, and an air exhausting fan 24 is provided on a front face side of the apparatus 20. The inside of the apparatus 20 is partitioned by a partition plate 26 which extends from the rear face side to an intermediate position toward the front face side. A pair of printed circuit boards 28 and 30 are provided horizontally in this order from below in one of the spaces of the partitioned inside, and a pair of printed circuit boards 32 and 34 are provided horizontally in this order from below in the other space of the partitioned inside. Here, it is assumed that the heat sink 2 and the integrated circuit package 4 in the present embodiment are mounted on the printed circuit board 32. Air flows in the apparatus are indicated by a plurality of arrow marks in FIG. 3. In the present embodiment, since the directions of the air admission opening 22 and the air discharging ports 14 of the heat sink 2 can be set so that they may conform to the air flows in the housing 20 which depend upon the air admission opening 22 and the air exhausting fan 24, the cooling air flows are disordered less likely, and effective cooling of the heat generating element can be achieved.

Further, where an element 36 which is weak in heat is mounted at a location on the printed circuit board 32 sidewardly of the heat sink 2 as shown in FIG. 3, while there is the possibility with a conventional heat sink that the element 36 may be damaged by a hot wind discharged from the bottom of the heat sink, in the present embodiment, since cooling air flows are disordered less likely, it is prevented that the element 36 is damaged by heat. Further, with a conventional heat sink, since air blasting means such as a fan assembly is provided at an upper portion of the heat sink, another printed circuit board (in FIG. 3, the printed circuit board 34) must be mounted with some space left above the heat sink, and a cumbersome operation is required. However, in the present embodiment, since the heat sink 2 has the cover member 8 and the air sucking port 12 is provided sidewardly of the cover member 8, the printed circuit board 34 may be provided in contact with the upper face of the heat sink 2, and accordingly, a complicated operation is not required upon mounting of the printed circuit board 34.

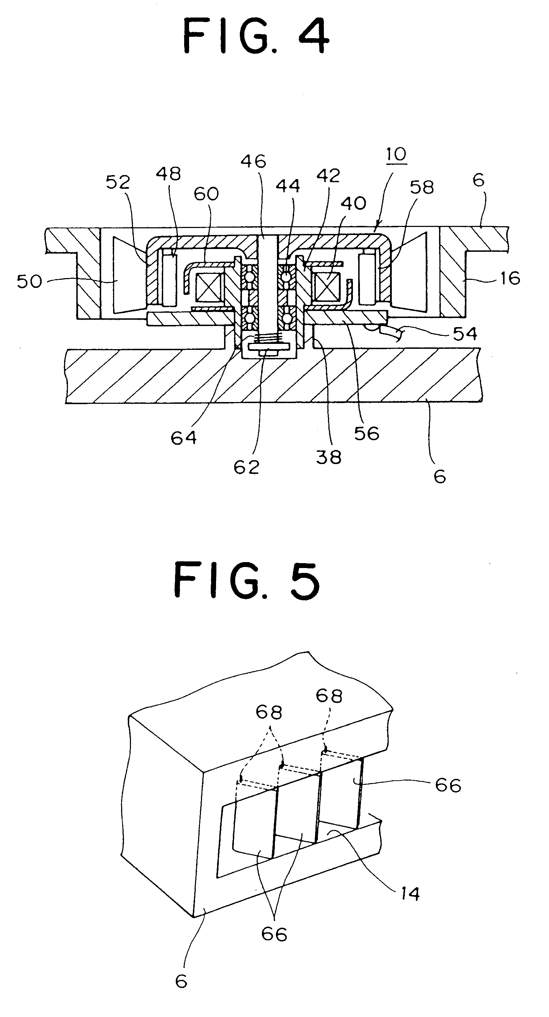

FIG. 4 is a sectional view of the fan assembly in the present embodiment. A fan mounting portion 38 is formed in the inside of the base member 6, and the fan assembly 10 as air blasting means is secured to the fan mounting portion 38. The fan assembly 10 is constituted from a stator 42 force fitted in and secured to the fan mounting portion 38 and provided with a coil 40, a shaft 46 erected uprightly at the center of the stator 42 by way of a bearing 44, a rotor 52 secured to the shaft 46 and having a magnet 48 and a propeller 50 secured to an inner circumferential wall and an outer circumferential wall thereof, respectively, and a printed circuit board 56 to which a lead 54 is connected. A motor driving circuit not shown is mounted on the printed circuit board 56. Meanwhile, reference numeral 58 denotes a ring yoke, 60 a yoke, 62 a cut washer mounted on the shaft 46, and 64 a spring for biasing the shaft 46 downwardly. It is to be noted that the reason why the annular projection 16 is provided around the fan assembly 10 in the present embodiment is that it is intended to assure a sufficient difference in static pressure between the inside of the base member 6 and the inside of the cover member 8.

FIG. 5 is a perspective view showing another example of an air discharging port formed in a base member. In the present example, one or more comparatively large air discharging ports 14 are formed in a side face of the base member 6, and a plurality of doors 66 are provided in the inside of each of the air discharging ports 14. Each of the doors 66 is mounted for pivotal motion around a shaft 68 provided on the base member 6, and the sectional shape of the door 66 in a plane perpendicular to the shaft 68 is, for example, a wedge shape as shown in FIG. 5. The sectional shape may be a stream lining shape as hereinafter described.

In the present embodiment, by selectively opening and closing a plurality of ones of the doors 66, the air discharging positions in each of the air discharging ports 14 can be set freely, and the air discharging directions can be set freely by the opening and closing angles of the individual doors. Accordingly, when it is tried to apply the heat sink having such air discharging port or ports to an apparatus which is constructed so that cooling air flows may be produced in the inside, it is easy to direct the air discharging port or ports toward the downstream side of the air flow after the heat sink is mounted. Further, it is easy to prevent a hot wind discharged from the heat sink from blowing to an element which is weak in heat. Further, in the present embodiment, since particularly open ones of the doors 66 receive air flows from the fan assembly and function as heat radiation fins, a high heat radiation property can be assured.

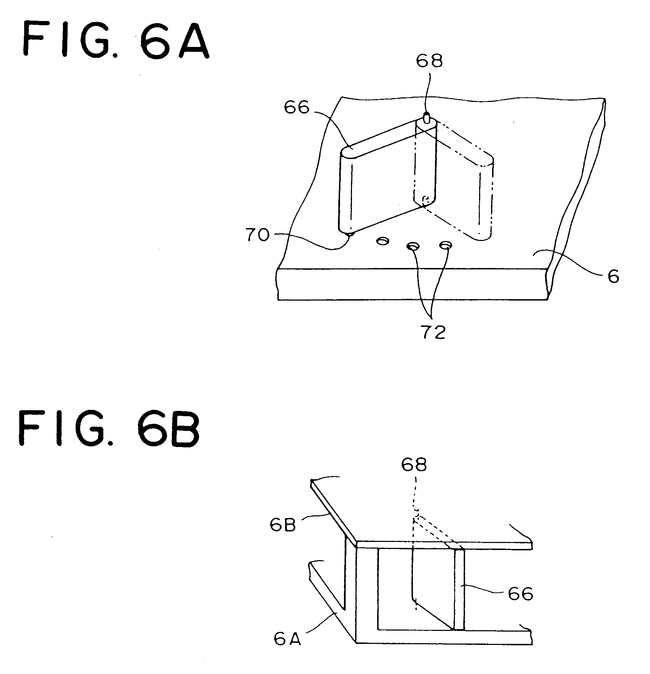

FIG. 6A and FIG. 6B are perspective views showing different examples of a door. In the example shown in FIG. 6A, a projection 70 is formed on a lower face of the door 66 which makes pivotal motion around a shaft 68, and a plurality of locking holes 72 are provided on the upper face of the base member 6 along a locus of movement of the projection 70. And, as the projection 70 is seated in one of the locking holes 72, the pivoting angle of the door 66 can be set stepwise. With the present embodiment, the opening and closing angle of the door 66 can be set readily. Meanwhile, in the example shown in FIG. 6B, the base member 6 is divided into a portion 6A which provides a lower face and support posts of the base member 6 and another portion 6B which provides an upper face of the base member 6. When it is tried to assemble the portions 6A and 6B into a unitary member, the door 66 is held between the portions 6A and 6B such that the pivoting angle of the door 66 is fixed by frictional forces between the upper and lower faces of the door 66 and the inner face of the base member. In the present embodiment, the opening and closing angle of the door 66 can be adjusted against the frictional forces by providing a pivoting force higher than a certain level to the door 66.

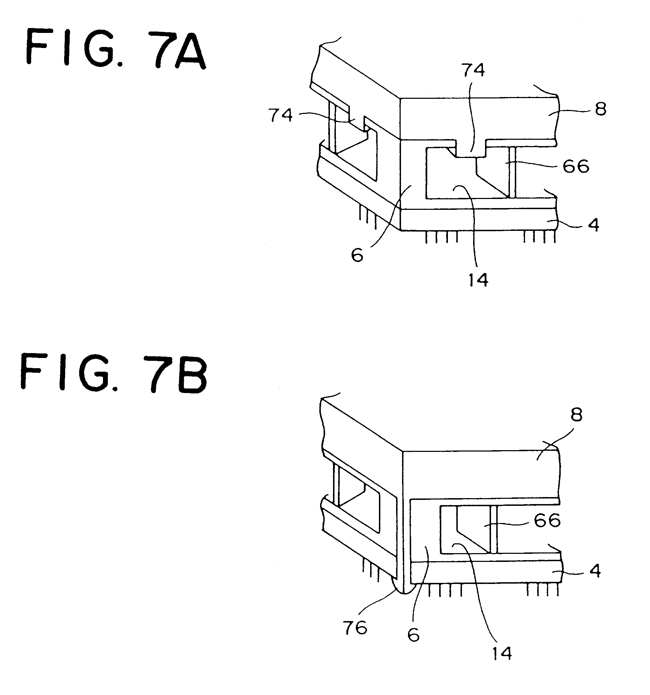

FIG. 7A and FIG. 7B are perspective views showing examples of a securing structure for the cover member. In the example shown in FIG. 7A, the cover member 8 has a hook 74 on an edge of a lower face thereof, and the hook is arrested at the air discharging port 14 to secure the cover member 8 to the base member 6. In the example shown in FIG. 7B, the cover member 8 has a hook 76 on an edge (in the example shown, at the four corners of the cover member) of a lower face thereof, and an end portion of the hook 76 is arrested at an edge of a lower face of the integrated circuit package 4 to secure the cover member 8 and the base member 6 to the integrated circuit package 4. With the example shown in FIG. 7B, the heat sink can be mounted readily onto the integrated circuit package 4 without independently securing the base member 6 to the integrated circuit package 4.

As described above, according to the present invention, an effect that a heat sink which is high in cooling efficiency and superior in reliability can be provided is provided.

While the invention has been described with reference to particular embodiments, these embodiments are given by way of illustration only and not limitative of the present invention. The scope of the invention is defined by the appended claims and all changes and modifications as fall within the equivalence of the scope of the claims are therefore to be embraced by the invention.

## Claims

1. A heat sink (2) including a housing having a base member (6) with a lower face for contacting a heat generating element, and an air displacing means (10), characterised in that:
the housing includes an air intake port (12) and at least one air discharge port (14) arranged at offset points in the housing respectively, and the air displacing means (10) is provided in the housing for urging air between the air intake port (12) and the or each air discharge port (14).

2. A heat sink (2) according to claim 1 in which:
the housing includes a cover member (8) provided over the base member (6), the air intake port (12) being provided in the cover member (8) and the air discharge port (14) being provided in the base member (6),
the base member (6) contains a cavity which communicates with the inside of the cover member (8) through an opening (18) provided in an upper face of the base member (6), and the air displacing means (10) is provided in the opening (18) so as to encourage a flow of air from the air intake port (12), through the cover member (8) and into the base member (6) and to the air discharge port (14).

3. A heat sink (2) according to claim 1 or 2, in which a plurality of doors (66) are provided in the or each air discharging port (14) which can be selectively opened and closed to set the direction of discharge of air.

4. A heat sink according to claim 3, in which each door (66) is adapted for pivotal motion and may be locked in different orientations.

5. A heat sink according to claim 4 in which each of the doors (66) has a projection (70) provided on a lower portion thereof and a plurality of locking holes (72) are provided in an upper face of the base member (6) along a locus of movement of each of the projections (70) so that the pivoting angle of each door may be set stepwise by the seating of each projection (70) in one of said locking holes (72).

6. A heat sink according to any one of claims 2 to 5 in which the cover member (8) includes at least one fastening means (74) adapted to interact with one or more of the air discharge ports (14) for fastening the cover member (8) to the base member (6).

7. A heat sink according to any of claims 2 to 6, in which the cover member (8) includes at least one fastening means (76) adapted to interact with an edge of a lower face of a heat generating element in order that the cover member (8) and the base member (6) may be fastened to the heat generating element.

8. An apparatus including a heat sink according to any preceding claim, in which the apparatus includes a printed circuit board having a heat generating element comprising an integrated circuit package mounted on the printed circuit board.
